(19) Europäisches Patentamt / European Patent Office / Office européen des brevets

(11) **EP 2 660 978 A1**

(12) **DEMANDE DE BREVET EUROPEEN**

(43) Date de publication:
**06.11.2013 Bulletin 2013/45**

(51) Int Cl.:
***H03K 17/04*** *(2006.01)*

(21) Numéro de dépôt: **13165997.1**

(22) Date de dépôt: **30.04.2013**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **03.05.2012 FR 1254076**

(71) Demandeur: **ALSTOM Transport SA**
**92300 Levallois-Perret (FR)**

(72) Inventeurs:
• **Bou Saada, Johnny**
 **1330 Rixensart (BE)**
• **Al Kayal, Fisal**
 **1090 Jette (BE)**

(74) Mandataire: **Blot, Philippe Robert Emile**
**Cabinet Lavoix**
**2, place d'Estienne d'Orves**
**75441 Paris Cedex 09 (FR)**

(54) **Un dispositif comportant un composant électronique avec une grande vitesse de commutation**

(57) L'invention concerne un dispositif (10) de commutation électrique comprenant :
- au moins un composant (12) électronique ;
- un circuit (14) de commande adapté à commander le ou chaque composant (12),

chaque composant (12) étant relié au circuit (14) de commande par une liaison (18) respective,
caractérisé en ce que le composant (12) a une vitesse de commutation supérieure à 10 kA/$\mu$s ou supérieure à 20 kV/$\mu$s et que la ou chaque liaison (18) présente une inductance inférieure à 10 nH.

FIG.1

EP 2 660 978 A1

**Description**

La présente invention concerne un dispositif de commutation électrique pour un composant électronique ayant une vitesse de commutation rapide. La présente invention s'applique notamment dans le domaine ferroviaire.

De nos jours, des composants électroniques réalisés dans un matériau semi-conducteur avec un grand gap sont commercialisés. A titre d'exemple, des composants en carbure de silicium ou en nitrure de gallium sont présents sur le marché. Ces composants impliquent moins de pertes et fonctionnent à une vitesse de commutation plus élevée que les composants réalisés avec des matériaux ordinaires. En outre, leur température de jonction est généralement plus élevée.

Il est souhaitable d'utiliser ce type de composants dans les convertisseurs de puissance parce qu'ils apportent un gain en masse, en volume et diminuent les pertes électriques d'un facteur assez important.

Les composants en carbure de silicium sont proposés pour plusieurs types de composants : les diodes, les transistors dits MOSFETS (acronyme anglais de Metal Oxyd Semi conductor Field Effect Transistor, qui se traduit par transistor à effet de champ à structure métal-oxyde-semi-conducteur) ou des transistors de type JFET (acronyme anglais pour « Jonction Field Effect Transistor »).

Ces composants existent sous diverses formes, que ce soient des petits conditionnements (aussi appelés sous le terme anglais de « Packaging ») ou sous la forme d'un module de puissance. De manière connue en soi, un module de puissance comporte généralement plusieurs composants, par exemple en parallèle.

Quelle que soit la forme sous laquelle le composant est vendu, plusieurs impératifs sont à considérer pour pouvoir bénéficier des avantages procurés par l'emploi de ces nouveaux composants. En particulier, la fréquence de découpage utilisée doit être de l'ordre de quelques dizaines de kHz (kiloHertz) pour minimiser la taille des composants passifs. La vitesse de commutation doit également être élevée pour minimiser les pertes par commutation. Dans le cadre de cette invention, une vitesse de commutation élevée est une vitesse de commutation d'au moins 10 KiloAmpères par microseconde (kA/µs) ou 20 KiloVolts par microseconde (kV/µs).

Il est connu d'utiliser un composant appelé IPM (acronyme anglais pour Intelligent Power Module). Dans ce cas, l'ensemble des composants est dans un module de puissance sur lequel est moulée une pièce. Cette pièce contient le circuit de commande qui est ainsi monobloc.

Néanmoins, un composant IPM selon la conception actuelle ne permet pas de profiter pleinement des avantages du carbure de silicium à cause de problème d'oscillation entre la commande et le semi-conducteur de puissance quand la vitesse de commutation devient élevée (supérieures à 10 kA/µs).

Il existe donc un besoin pour un dispositif permettant de bénéficier de la vitesse de commutation élevée d'un composant électronique à commutation rapide.

A cet effet, l'invention propose un dispositif de commutation électrique comprenant au moins un composant électronique et un circuit de commande adapté à commander le ou chaque composant. Chaque composant est relié au circuit de commande par une liaison respective. Le composant a une vitesse de commutation supérieure à 10 kA/µs ou supérieure à 20 kV/µs et la ou chaque liaison présente une inductance inférieure à 10 nH.

Suivant des modes de réalisation particuliers, le dispositif comprend une ou plusieurs des caractéristiques suivantes, prise(s) isolément ou suivant toutes les combinaisons techniquement possibles :

-   le composant est réalisé en un matériau choisi dans le groupe consistant en le diamant, le carbure de silicium et le nitrure de gallium
-   le circuit de commande comporte un amplificateur de signal, la liaison reliant l'amplificateur au composant,
-   le composant fonctionne pour une fréquence de découpage comprise entre 1 kHz et 500 kHz,
-   le composant fonctionne pour une fréquence de découpage comprise entre 10 kHz et 40 kHz,
-   le dispositif comporte N composants, N étant un entier strictement supérieur à 1 et le circuit comporte [(N + 1)/2] unités de commande où [] est la partie entière, les unités de commande étant reliées chacune à un ou deux composant (s) électronique(s),
-   le dispositif comporte N composants, N étant un entier strictement supérieur à 1, et dans lequel le circuit comporte N unités de commande, chaque composant étant relié à une unité différente,
-   le dispositif comporte une pluralité de liaison, chaque liaison présentant la même inductance à 3% près,
-   la liaison a une inductance inférieure à 5 nH,
-   le composant a une vitesse de commutation supérieure à 15 kA/µs ou 30 kV/µs,
-   le circuit comporte plusieurs unités de commande, synchronisées entre elles, et
-   les unités sont synchronisées par connexion de chacune des sorties des unités à un même potentiel.

L'invention concerne aussi un convertisseur de puissance comportant un dispositif tel que précédemment décrit.

L'invention a également pour objet un véhicule ferroviaire comportant le convertisseur de puissance tel que décrit précédemment.

D'autres caractéristiques et avantages de l'invention apparaîtront à la lecture de la description détaillée qui suit de mode de réalisation de l'invention, donnée à titre d'exemple uniquement et en référence aux dessins qui sont :

- figure 1, une vue schématique d'un exemple de dispositif de commutation électrique selon l'invention,
- figure 2, une vue schématique d'un autre exemple de dispositif,
- figure 3, un graphique illustrant le résultat d'une simulation numérique pour un dispositif selon l'état de la technique,
- figure 4, un graphe illustrant le résultat d'une autre simulation selon un dispositif de l'état de la technique,
- figure 5, un graphique illustrant le résultat obtenu avec un dispositif selon l'invention,
- figures 6 et 7, des graphiques illustrant les résultats de simulation de commutation d'un dispositif selon l'état de la technique, et
- figures 8 et 9, des graphiques illustrant le résultat de simulation de commutation pour un dispositif selon l'invention.

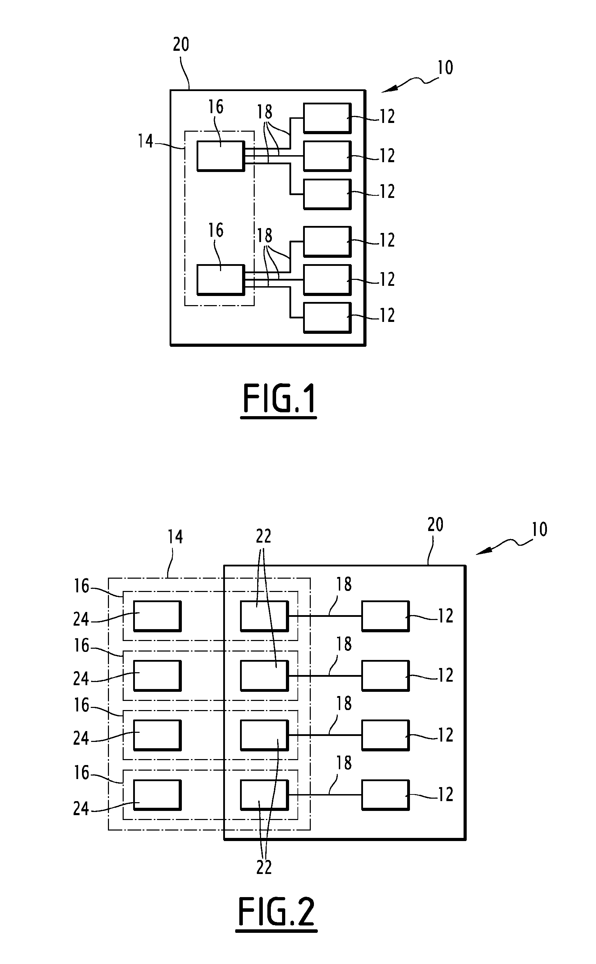

Un dispositif de commutation électrique 10 représenté à la figure 1 comporte six composants 12 électroniques. Les composants 12 ont une vitesse de commutation rapide. Par vitesse de commutation rapide, il est entendu une vitesse de commutation supérieure à 10 kA/$\mu$s ou à 20 kV/$\mu$s.

Selon un mode de réalisation préféré, la vitesse de commutation, des composants 12 est supérieure à 15 kA/$\mu$s (respectivement 30 kV/$\mu$s).

A titre d'exemple, des composants 12 réalisés en diamant, en carbure de silicium ou en nitrure de gallium présentent une vitesse de commutation rapide.

Les composants 12 sont, à titre d'illustration, un transistor MOSFET, un transistor JFET ou tout autre composant électronique ayant la vitesse de commutation précitée.

Le dispositif 10 comporte également un circuit 14 de commande ou allumeur. Le circuit 14 de commande permet de commander les composants 12.

Par exemple, le circuit de commande 14 est propre à émettre une commande qui est imposée à l'entrée « grille » d'un transistor.

Selon l'exemple de la figure 1, le circuit 14 de commande comprend plusieurs unités 16 de commande. Dans le cas illustré, le circuit 14 comporte deux unités 16.

Selon la figure 1, en outre, les sorties de chacune des unités 16 sont reliées ensemble. Cela implique que les sorties de l'ensemble des unités 16 sont toutes à un même potentiel. Autrement dit, les sorties délivrent le même signal. Ainsi, il est assuré une bonne synchronisation des unités 16.

Une telle synchronisation garantit que le signal de commande arrive en même temps à tous les composants 12. Ainsi, le courant de puissance est bien réparti entre tous les composants 12.

En variante, ces sorties ne sont pas connectées ensemble. Dans ce cas, la séquence de l'allumage (ou blocage) de chaque unité 16 est contrôlée pour améliorer l'équilibrage entre les composants 12 et faciliter la réalisation du dispositif 10.

Là encore, via la séquence d'allumage, dans cette variante, les unités de commande 16 sont synchronisées entre elles.

Chaque composant 12 est relié à une unité 16 via une liaison 18.

Ainsi que cela est illustré par la figure 1, la liaison 18 est de type filaire, étant entendu que tout type de liaison assurant une conductivité électrique entre le composant 12 et l'unité 16 associée est envisageable. A titre d'illustration, ces liaisons sont réalisées avec des fils en aluminium (désigné sous le terme générique anglais de « wire bonding ») ou sur circuit imprimé (par exemple de type DBC, DBC étant l'acronyme anglais de « Direct Bond Copper »). La longueur de ces fils doit être limitée afin de pouvoir accélérer la vitesse de commutation sans rendre le système de commande oscillant. Une distance de 1 cm donne une inductance de câblage de l'ordre de 10 nH. Cette distance de 1 cm semble un bon compromis entre une vitesse de commutation élevée et un dispositif 10 réalisable pour un coût de fabrication raisonnable.

Chacune des liaisons 18 présente une inductance inférieure à 10 nH (nanoHenry). Une telle valeur d'inductance assure une commutation rapide du composant 12 du fait que le circuit 14 est placé à proximité du composant 12 commandé.

De préférence, les liaisons 18 présentent toutes la même inductance à 3% près pour assurer une vitesse de commutation rapide de tous les composants 12.

De manière à augmenter encore la qualité de commutation du composant, il est préféré que l'inductance de la liaison 18 soit inférieure à 5 nH.

Pour obtenir aisément une inductance aussi faible pour la liaison 18, il est proposé selon la figure 1 que le circuit 14 de commande soit relativement proche des composants 12. On entend par proche que le circuit 14 est au plus à 10 mm environ de chaque composant 12.

Ainsi, le dispositif 10 se présente sous la forme d'un module de puissance 20 intégrant les composants 12 et le circuit de commande 14. Un module de puissance 20 a en effet des dimensions restreintes. Selon l'exemple de la figure 1, il s'agit d'un boîtier ayant la forme d'un parallélépipède rectangle dont aucune arête n'est plus grande que 12 cm. Cette intégration présente l'avantage de rendre le dispositif peu encombrant.

Pour chacune des unités 16, au plus trois composants 12 lui sont associés. Cela permet de placer les composants 12 relativement proches des unités 16.

En variante, pour un dispositif 10 comportant N composants électroniques 12, il est avantageux de munir le circuit 14 de commande avec :

$$[ (N+1)/2 ] \text{ unités 16 ou [-] désigne la partie entière.}$$

En effet, chacune des unités 16 est connectée à au plus deux composants 12. Ainsi, la distance entre l'unité 16 et les composants 12 auxquels l'unité 16 est reliée est fortement réduite.

Dans les cas particuliers où le nombre N est un entier impair, le module 20 comporte :

$$(N-1)/2 + 1 \text{ unités 16.}$$

(N - 1) /2 unités 16 sont reliées chacune à deux composants 12 et une seule unité 16 est reliée à un seul composant 12. Ce composant 12 associé à la seule unité est placé au milieu des autres composants 12.

La figure 2 illustre une autre variante permettant d'obtenir une inductance associée de faible valeur pour chaque liaison 18 entre un composant 12 et l'unité 16.

Selon cette variante, chaque composant 12 est associé à une unité 16 de commande. Selon cette figure le dispositif 10 ne comporte que quatre composants 12. Le circuit 14 de commande comporte ainsi quatre unités 16. Disposer d'une seule unité 16 de commande par composant 12 permet d'obtenir un meilleur contrôle des composants 12.

En outre, selon l'exemple de la figure 2, les unités 16 comportent une première sous-unité 22 et une deuxième sous-unité 24. La première sous-unité 22 comporte les éléments de l'unité 16 influençant le bon fonctionnement du composant 12 pour des hautes vitesses de commutation. Ainsi, cette sous-unité 22 peut être considérée comme la partie active de l'unité 16. A titre d'exemple elle comporte un amplificateur de signal Cette première sous-unité 22 est placée dans le module 20 afin d'être à proximité des composants 12.

La deuxième sous-unité 24 n'est pas intégrée dans le module 20. Il en résulte que la sous-unité 24 est plus éloignée des composants 12 que la sous-unité 22. La sous-unité 24 comprend par exemple, un convertisseur continu-continu, des moyens assurant l'isolation galvanique, un contrôleur de gestion de défauts et des moyens ayant d'autres fonctions selon les modes de réalisation considérés. Dans le mode de réalisation de la figure 1, les fonctions des éléments de la sous-unité 24 sont éloignées parce qu'elles n'ont pas d'influence sur le bon fonctionnement du composant 12 pour des hautes vitesses de commutation. Notamment, la sous-unité 24 est à une distance supérieure à 10 cm du module 20.

De ce fait, dans le module 20, seule la sous-unité 22 est présente dans le module 20.

En fonctionnement, le dispositif 10 de commutation électrique bénéficie de la propriété de commutation rapide du composant 12. La faible valeur de l'inductance des liaisons 18 dans l'invention permet notamment d'obtenir cela. Pour le montrer, des tests et des simulations ont été réalisés.

Le tableau 1 suivant donne les résultats de tests menés pour plusieurs configurations. Les configurations 1 et 2 sont selon l'état de la technique alors que la configuration 3 est selon l'invention. Le tableau 1 précise les performances associées pour la commutation. Plus précisément, la vitesse de commutation du composant 12 exprimée en kA/µs et utilisée pour le test est donnée. Le temps de commutation est aussi donné. Ce temps de commutation est exprimé en ns (nanosecondes). En outre, l'énergie de commutation qui correspond aux pertes par commutation est aussi donnée. Elle est exprimée en mJ (milliJoules) et est mesurée dans une configuration où les composants fonctionnent à 750 V (Volts) pour 500 A (ampères).

*Tableau 1 : influence de la variation de l'inductance sur la vitesse de commutation du composant*

| Configuration considérée | Inductance de la liaison (nH) | Vitesse de commutation du composant (kA/µs) | Energie de commutation (mJ) | Temps de commutation (ns) |
|---|---|---|---|---|
| Configuration 1 | 1000 | 3,2 | 58,1 | 155 |
| Configuration 1 | 1000 | 3,0 | 61,9 | 165 |
| Configuration 2 | 100 | 7,0 | 26,6 | 71 |

(suite)

| Configuration considérée | Inductance de la liaison (nH) | Vitesse de commutation du composant (kA/$\mu$s) | Energie de commutation (mJ) | Temps de commutation (ns) |
|---|---|---|---|---|
| Configuration 2 | 100 | 6,5 | 28,9 | 77 |
| Configuration 3 | 10 | 11,1 | 16,9 | 45 |

La configuration 1 correspond à un cas où le circuit de commande est placé à l'extérieur du module 20. Cette configuration correspond à la configuration traditionnelle pour des semi-conducteurs ayant une vitesse de commutation relativement lente. Dans ce cas, la liaison entre le circuit de commande et le composant est généralement de l'ordre de 1000 nH.

Pour la configuration 1, il est observé, pour une vitesse de commutation de l'ordre de 3,0 kA/$\mu$s, des pertes de l'ordre de 60 mJ et un temps de commutation de l'ordre de 160 ns. La vitesse de commutation est donc relativement faible, le temps de commutation lent et l'énergie de commutation importante. Cela implique ainsi une limitation de la fréquence de découpage et des pertes importantes. De ce fait, il n'est pas possible de minimiser considérablement la taille des composants passifs utilisés dans un convertisseur de puissance impliquant l'usage des composants testés dans la configuration 1. De ce fait, selon la configuration 1, le convertisseur comprenant les composants 12 sera relativement lourd et coûteux.

La configuration 2 selon l'état de la technique correspond au cas du composant IPM décrit précédemment. Dans ce cas, l'inductance de la liaison est plus faible de l'ordre de 100 nH. La vitesse de commutation du composant est plus importante que dans le cas de la configuration 1. En outre, par comparaison à la configuration 1, bien que la vitesse de commutation soit plus rapide (7,0 kA/$\mu$s), l'énergie de commutation (26,6 mJ) et le temps de commutation (71 ns) sont environ deux fois moins importants.

Le dernier cas correspond à celui de l'invention. Dans ce cas, l'inductance de la liaison est de 10 nH. Il est observé que pour une vitesse de commutation de 11,1 kA/$\mu$s pour les composants 12, l'énergie de commutation est de 17 mJ et le temps de commutation de seulement 45 ns. Cela montre que l'utilisation d'une inductance réduite à 10 nH permet d'obtenir une bonne commutation.

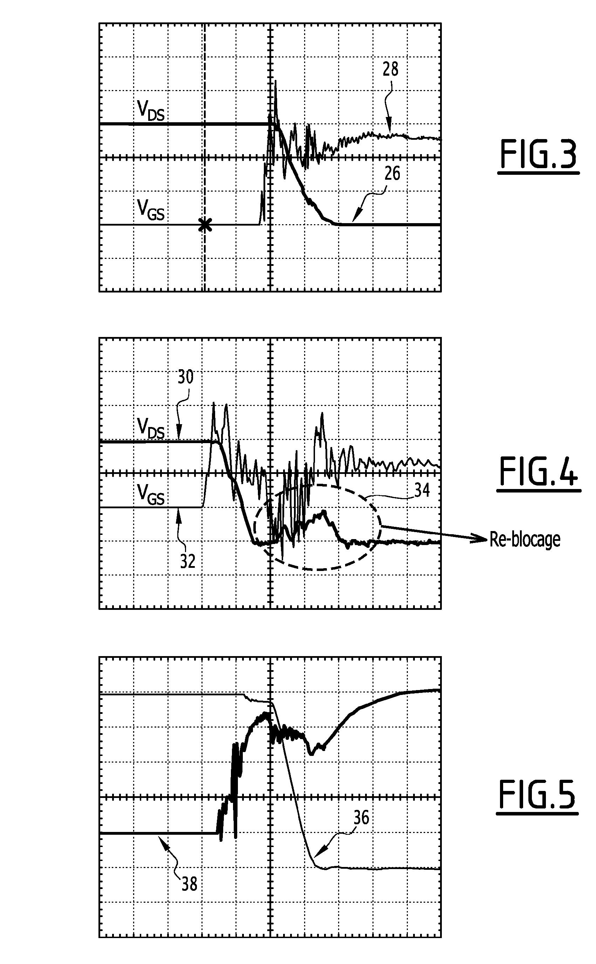

Des résultats d'autres tests d'un circuit de commande commandant un composant 12 sont présentés sur les figures 3, 4 et 5. Dans ce cas, le composant 12 est un transistor, un MOSFET de puissance qui comporte de manière connue en soi un drain, une source et une grille. Le transistor MOSFET utilisé est un transistor MOSFET en carbure de silicium de la marque CRI (référence DMF 20 120 D). Chacun des graphes des figures 3, 4 et 5 représente le résultat d'un test selon plusieurs configurations. Les paramètres variables sont l'inductance de la liaison 18 entre le circuit 14 de commande et le composant 12 à piloter et la vitesse de commutation du composant 12.

Selon l'exemple de la figure 3, l'inductance de câblage est de 100 nH entre le circuit de commande et le transistor MOSFET. Cela correspond en particulier à la configuration 2 selon l'état de la technique. Dans le cas de la figure 3, le transistor MOSFET est piloté à une faible vitesse de commutation de l'ordre de 1,5 kV/$\mu$s. Est représentée sur la figure 3 l'évolution temporelle de deux courbes 26 et 28 sous la forme d'un oscillogramme, l'unité de temps étant de 100 ns/carreau.

La première courbe 26 est une courbe illustrant l'évolution temporelle de la tension entre le drain et la source du transistor. Un carreau représente 100 V. La seconde courbe 28 est la courbe de l'évolution de la tension entre la grille et la source du transistor. Cette courbe 28 est représentée avec une ordonnée correspondant à 5 V/carreau.

Dans le cas de la figure 3, entre la commande illustrée par la courbe 28 et le signal en sortie du transistor, il n'apparaît pas de distorsion majeure du signal. Cela correspond au fait que pour cette faible vitesse de commutation, le dispositif est capable de fonctionner.

La figure 4 illustre la variation temporelle obtenue pour une même configuration mais une vitesse de commutation plus élevée, à savoir 6 kV/$\mu$s.

La figure 4 est également sous la forme d'un oscillogramme, dont l'unité de temps est de 50 ns/carreau.

La variation temporelle de la tension entre le drain et la source est représentée à la courbe 30 tandis que la courbe 32 illustre la variation temporelle de la tension entre la grille et la source.

L'unité dé variation n'est pas la même entre les courbes 30 et 32. Pour la courbe 32, un carreau représente 10 V alors que pour la courbe 30, un carreau représente 100 V.

L'élément le plus remarquable de cette figure 4 est le phénomène de re-blocage observé dans la partie encerclée 34. Les phénomènes de re-blocage ou ré-amorçage sont liés à la résonance entre le circuit 14 de commande et le transistor 12. L'origine de ces oscillations est l'inductance relativement élevée de la liaison entre ces deux éléments.

Ceci illustre bien que dans la configuration 2 selon l'état de la technique, il n'est pas possible d'augmenter la vitesse de commutation au-delà de 10 kA/$\mu$s ou de 20 kV/$\mu$s. Cela est possible pour un dispositif 10 selon l'invention.

Le résultat expérimental obtenu est montré en figure 5. Là encore, la figure 5 se présente sous la forme d'un oscillogramme. Est représentée l'évolution temporelle de la tension entre le drain et la source et de la tension entre la grille et la source.

La courbe 36 qui correspond à la tension entre le drain et la source est représentée avec les unités suivantes : 5 V/carreau et 100 ns/carreau en abscisse. La courbe 38 est représentée avec une échelle de 100 V/carreau en ordonnée et de 100 ns/carreau en abscisse.

Dans ce cas, il n'est pas observé d'oscillations correspondant au re-blocage. Cela montre que pour une inductance relativement faible, inférieure à 10 nH, la commutation du transistor 12 est stable et rapide.

Les résultats des figures 3, 4 et 5 ont été illustrés dans le cas où le circuit 14 de commande pilote un seul composant 12.

Dans le cas d'un module de puissance, plusieurs composants (puce du semi-conducteur) sont mis en parallèle pour former un interrupteur pouvant supporter un courant plus important.

Selon l'état de la technique, un seul circuit 14 de commande est utilisé pour piloter tous les composants 12 en parallèle et les liaisons 18 associées présentent des inductance différentes (des écarts supérieurs à 3%) et assez importantes en valeur (supérieure à 10 nH).

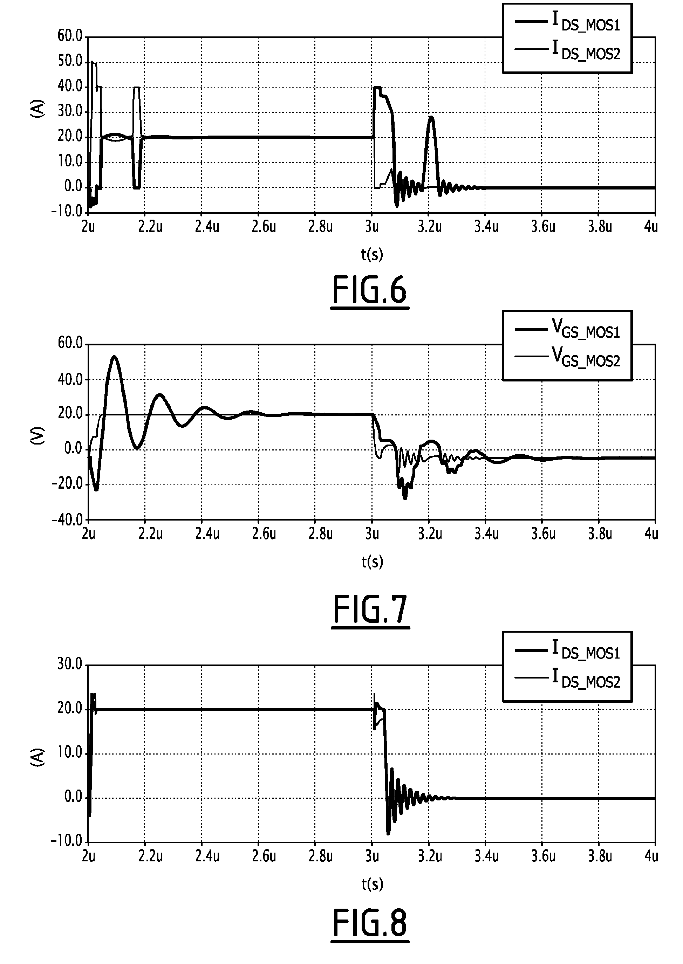

Les figures 6 et 7 montrent les résultats de simulations de commutation de deux transistors 12 de type MOSFET en carbure de silicium en parallèle lorsqu'elles sont pilotées par un seul circuit 14 de commande.

Il est représenté dans ces deux figures 6 et 7 l'évolution temporelle du courant entre le drain et la source du composant 12 ainsi que celle de la tension entre la grille et la source pour les deux transistors 12. Des oscillations sont observées sur les courbes des courants et des tensions.

Ces oscillations sont dues à l'inductance différentielle qui est trop importante entre les différentes liaisons 18 reliant le circuit 14 de commande et les composants 12.

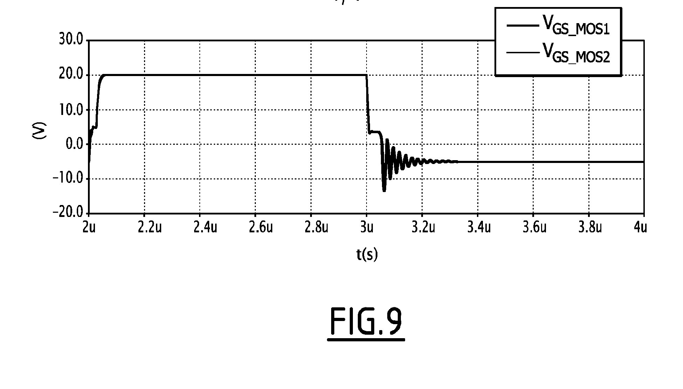

Les figures 8 et 9 illustrent le même cas que les figure 6 et 7, sauf que la configuration selon l'invention est utilisée. Dans ce cas, la vitesse de commutation des composants 12 peut être rendue beaucoup plus rapide parce que le comportement du module en commutation rapide est stable.

Néanmoins, sur ces deux figures 8 et 9, il peut être observé qu'il reste des oscillations sur les courbes des courants et des tensions. Ces oscillations correspondent au fait qu'il reste toujours une inductance résiduelle entre les composants 12 et le circuit 14. Ces oscillations commencent à apparaître une fois que la vitesse de commutation devient supérieure à 12 kA/µs même si l'inductance est très faible.

Cela correspond au fait qu'il est préférable que les unités 16 de commande soient synchronisées. Une telle synchronisation garantit que le signal de commande arrive en même temps à tous les composants 12. Ainsi, le courant de puissance est bien réparti entre tous les composants 12.

L'avantage de l'invention proposé est d'optimiser la commutation du module 20 de puissance utilisant un semi-conducteur 12 de puissance très rapide. La commutation est, en outre, rendue stable.

Cette optimisation permet de monter en fréquence de découpage, et donc, permet d'utiliser d'autres types de matériaux magnétiques qui sont bien adaptés pour les fréquences de découpages élevées. De tels matériaux font que le convertisseur de puissance dans sa globalité présente une masse moins importante et un volume réduit. A titre d'exemple, le poids d'un onduleur en silicium pour 50 kW (kiloWatts) est de l'ordre de 90 kilogrammes alors que le même onduleur en carbure de silicium ne fait que 33 % de cette masse.

La bonne utilisation du carbure de silicium aide aussi à diminuer les pertes des convertisseurs de puissance. Par conséquent, la chaleur dégagée par effet Joule diminue. Le système de refroidissement peut alors être moins performant. De ce fait, il en résulte des économies de coût.

**Revendications**

1. Dispositif (10) de commutation électrique comprenant :

   - au moins deux composants (12) électroniques ;
   - un circuit (14) de commande adapté à commander le ou chaque composant (12), **caractérisé en ce que** chaque composant (12) est relié au circuit (14) de commande par une liaison (18) respective,
   **en ce que** chaque composant (12) a une vitesse de commutation supérieure à 10 kA/µs ou supérieure à 20 kV/µs et **en ce que** la ou chaque liaison (18) présente une inductance inférieure à 10 nH.

2. Dispositif selon la revendication 1, dans lequel les composants (12) sont réalisés en un matériau choisi dans le groupe consistant en le diamant, le carbure de silicium et le nitrure de gallium.

3. Dispositif selon la revendication 1 ou 2, dans lequel le circuit de commande (14) comporte un amplificateur de signal, la liaison (18) reliant l'amplificateur au composant (12).

4. Dispositif selon l'une des revendications 1 à 3, dans lequel les composants (12) fonctionnent pour une fréquence de découpage comprise entre 1 kHz et 500 kHz.

5. Dispositif selon la revendication 4, dans lequel les composants (12) fonctionnent pour une fréquence de découpage comprise entre 10 kHz et 40 kHz.

6. Dispositif selon l'une quelconque des revendications 1 à 5, dans lequel le dispositif (10) comporte N composants (12), N étant un entier strictement supérieur à 1 et le circuit (14) comporte [(N + 1)/2] unités (16) de commande où [] est la partie entière, les unités (16) de commande étant reliées chacune à un ou deux composant(s) électronique (s) (12).

7. Dispositif selon l'une quelconque des revendications 1 à 5, dans lequel le dispositif (10) comporte N composants (12), N étant un entier strictement supérieur à 1, et dans lequel le circuit (14) comporte N unités (16) de commande, chaque composant (12) étant relié à une unité (16) différente.

8. Dispositif selon l'une quelconque des revendications 1 à 7, dans lequel le dispositif (10) comporte une pluralité de liaisons (18), chaque liaison (18) présentant la même inductance à 3% près.

9. Dispositif selon l'une quelconque des revendications 1 à 8, dans lequel la liaison (18) a une inductance inférieure à 5 nH.

10. Dispositif selon l'une quelconque des revendications 1 à 9, dans lequel chaque composant (12) a une vitesse de commutation supérieure à 15 kA/$\mu$s ou 30 kV/$\mu$s.

11. Dispositif selon l'une quelconque des revendications 1 à 10, dans lequel le ou chaque circuit (14) comporte plusieurs unités (16) de commande, synchronisées entre elles.

12. Dispositif selon la revendication 11, dans lequel chaque unité (16) comporte une sortie et les unités (16) sont synchronisées par connexion de chacune des sorties des unités (16) à un même potentiel.

13. Convertisseur de puissance comportant un dispositif (10) selon l'une quelconque des revendications 1 à 12.

14. Véhicule ferroviaire comportant le convertisseur de puissance selon la revendication 13.

## FIG.1

## FIG.2

$V_{DS}$

28

$V_{GS}$

26

FIG.3

30

$V_{DS}$

$V_{GS}$

34

32

Re-blocage

FIG.4

36

38

FIG.5

FIG.6

FIG.7

FIG.8

FIG.9

Europäisches
Patentamt

European
Patent Office

Office européen
des brevets

# RAPPORT DE RECHERCHE EUROPEENNE

Numéro de la demande

EP 13 16 5997

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2010/129837 A2 (SEMISOUTH LAB INC [US]; ROBIN KELLEY [US]) 11 novembre 2010 (2010-11-11) * alinéas [0004] - [0077]; figures 1-6,9-11 * | 1-14 | INV. H03K17/04 |
| X | US 2010/283515 A1 (KELLEY ROBIN LYNN [US] ET AL) 11 novembre 2010 (2010-11-11) * alinéas [0097] - [0103]; figures 5,6,11,16 * | 1-14 | |
| X | US 2010/271081 A1 (CAIAFA ANTONIO [US] ET AL) 28 octobre 2010 (2010-10-28) * alinéas [0002], [0003], [0029] - [0043]; figures 4-7 * | 1-14 | |

| | DOMAINES TECHNIQUES RECHERCHES (IPC) |
|---|---|
| | H03K |

Le présent rapport a été établi pour toutes les revendications

| Lieu de la recherche | Date d'achèvement de la recherche | Examinateur |
|---|---|---|
| La Haye | 19 août 2013 | Meulemans, Bart |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**                 EP 13 16 5997

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

19-08-2013

| Document brevet cité au rapport de recherche | | Date de publication | Membre(s) de la famille de brevet(s) | | Date de publication |
|---|---|---|---|---|---|
| WO 2010129837 | A2 | 11-11-2010 | AU | 2010245759 A1 | 24-11-2011 |
| | | | CA | 2759195 A1 | 11-11-2010 |
| | | | CN | 102428651 A | 25-04-2012 |
| | | | EP | 2427964 A2 | 14-03-2012 |
| | | | JP | 2012526487 A | 25-10-2012 |
| | | | KR | 20120026517 A | 19-03-2012 |
| | | | NZ | 596258 A | 28-06-2013 |
| | | | US | 2010283061 A1 | 11-11-2010 |
| | | | US | 2011210340 A1 | 01-09-2011 |
| | | | WO | 2010129837 A2 | 11-11-2010 |
| US 2010283515 | A1 | 11-11-2010 | AU | 2010247781 A1 | 24-11-2011 |
| | | | CA | 2759210 A1 | 18-11-2010 |
| | | | CN | 102422537 A | 18-04-2012 |
| | | | EP | 2430755 A2 | 21-03-2012 |
| | | | JP | 2012527178 A | 01-11-2012 |
| | | | KR | 20120030411 A | 28-03-2012 |
| | | | US | 2010283515 A1 | 11-11-2010 |
| | | | US | 2012218011 A1 | 30-08-2012 |
| | | | WO | 2010132460 A2 | 18-11-2010 |
| US 2010271081 | A1 | 28-10-2010 | CA | 2700013 A1 | 27-10-2010 |
| | | | DE | 102010016611 A1 | 28-10-2010 |
| | | | GB | 2469914 A | 03-11-2010 |
| | | | JP | 5010708 B2 | 29-08-2012 |
| | | | JP | 2010259324 A | 11-11-2010 |
| | | | US | 2010271081 A1 | 28-10-2010 |

EPO FORM P0460

Pour tout renseignement concernant cette annexe : voir Journal Officiel de l'Office européen des brevets, No.12/82